# EUROPEAN PATENT APPLICATION

(11) **EP 3 255 650 A1**
(43) Date of publication of application: **13.12.2017**
(21) Application number: 16173566.7
(22) Date of filing: 08.06.2016
(51) Int. Cl.: H01J 37/22

(54) **CATHODOLUMINESCENCE DETECTOR FOR USE IN A CHARGED PARTICLE MICROSCOPE**

(71) Applicant: FEI Company, Hillsboro, OR 97124-5793 (US)
(72) Inventor: Hlavenka, Petr, 61600 Brno (CZ); Uncovsky, Marek, 613 00 BRNO (CZ); Wandrol, Petr, 60200 Brno, Czech Republic (CZ)
(74) Representative: Bakker, Hendrik

(57) **Abstract**

A charged particle microscope having a vacuum chamber comprising:
- A sample holder, for holding a sample;
- A source, for producing a probing beam of charged particles;
- An illuminator, for directing said beam along an axis so as to irradiate the sample, also comprising:
- A detector, for simultaneous detection of multiple wavelengths in a polychromatic flux of photonic radiation emanating from the sample in response to said irradiation,
which detector comprises:
- A plurality of photosensitive surfaces, each of which produces an output signal in response to detected photonic radiation; and
- A plurality of optical filters, with mutually differing transmission characteristics, each associated with a respective one of said photosensitive surfaces and serving to filter photonic radiation falling thereon.

## Description

The invention relates to a detector for simultaneous detection of multiple wavelengths in a polychromatic flux of photonic radiation.

The invention also relates to a charged particle microscope having a vacuum chamber comprising:
- A sample holder, for holding a sample;
- A source, for producing a probing beam of charged particles;
- An illuminator, for directing said beam along an axis so as to irradiate the sample, also comprising:
- A detector as set forth above, for detecting radiation emanating from the sample in response to said irradiation.

The invention further relates to a method of using such a detector/microscope.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a sample (specimen) by a scanning electron beam precipitates emanation of "auxiliary" output radiation from the sample, in the form of secondary electrons, backscattered electrons, X-rays and cathodoluminescence (infrared, visible and/or ultraviolet photons), for example; one or more components of this output radiation is/are then detected and used for image accumulation purposes.
- In a TEM, the electron beam used to irradiate the sample is chosen to be of a high-enough energy to penetrate the sample (which, to this end, will generally be thinner than in the case of a SEM sample); the transmitted electrons emanating from the sample can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.org/wiki/Electron microscope
http://en.wikipedia.org/wiki/Scanning electron microscope
http://en.wikipedia.org/wiki/Transmission electron microscopy
http://en.wikipedia.org/wiki/Scanning transmission electron microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards non-electron-based charged particle microscopy, some further information can, for example, be gleaned from references such as the following:
https://en.wikipedia.org/wiki/Focused ion beam
http://en.wikipedia.org/wiki/Scanning Helium Ion Microscope
   - W.H. Escovitz, T.R. Fox and R. Levi-Setti, Scanning Transmission Ion Microscope with a Field Ion Source, Proc. Nat. Acad. Sci. USA 72(5), pp 1826-1828 (1975).
http://www.ncbi.nlm.nih.gov/pubmed/22472444

It should be noted that, in addition to imaging and performing (localized) surface modification (e.g. milling, etching, deposition, etc.), a charged particle microscope may also have other functionalities, such as performing spectroscopy, examining diffractograms, etc.

In all cases, a Charged Particle Microscope (CPM) will have a vacuum chamber comprising at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), *etc.* It will generally comprise one or more (charged-particle) lenses, and may comprise other types of (particle-)optical component also. If desired, the illuminator can be provided with a deflector system that can be invoked to cause its exit beam to perform a scanning motion across the sample being investigated.
- A sample holder, on which a sample under investigation can be held and positioned (e.g. tilted, rotated). If desired, this holder can be moved so as to effect scanning motion of the beam w.r.t. the sample. In general, such a sample holder will be connected to a positioning system such as a mechanical stage.

In the case of a transmission-type microscope (such as a (S)TEM, for example), the vacuum chamber will also comprise:
- An imaging system, which essentially takes charged particles that are transmitted through a sample (plane) and directs (focuses) them onto analysis apparatus, such as a detection/imaging device, spectroscopic apparatus (such as an EELS device), *etc.* As with the illuminator referred to above, the imaging system may also perform other functions, such as aberration mitigation, cropping, *etc.,* and it will generally comprise one or more charged-particle lenses and/or other types of particle-optical components.

Furthermore, a CPM will comprise:
- A detector (for detecting output radiation emanating from an irradiated sample), which may be unitary or compound/distributed in nature, and which can take many different forms, depending on the output radiation being detected. Examples include photodiodes, CMOS detectors, CCD detectors, photovoltaic cells, X-ray detectors (such as Silicon Drift Detectors and Si(Li) detectors), etc. In general, a CPM may comprise several different types of detector, selections of which can be invoked in different situations.
- A processor (electronic controller), *inter alia* for administrating/controlling certain operations within the CPM, executing software/firmware, performing autonomous runs, exchanging data with a user interface, *etc.*

In what follows, the invention may - by way of example - sometimes be set forth in the specific context of electron microscopy; however, such simplification is intended solely for clarity/illustrative purposes, and should not be interpreted as limiting.

A detector as hereabove described is, for example, known from US patent application US 2014/0194314 A1. This application discloses a particle-optical apparatus in the form of a SEM. The sample (inside the SEM's vacuum chamber) is irradiated with a beam of electrons. Optics, *e.g*. in the form of a parabolic mirror, are used to guide light (cathodoluminescence, CL) out of the vacuum chamber and into a spectrometer. In its paragraph [0036], the document mentions that "the speed and ease of multi-color NP-CL imaging may also be enhanced by optimization of CL optical collection efficiency and parallel imaging of different CL colors, *e.g*. with multiple CL detection paths or use of a broadband spectrograph" (whereby the abbreviation "NP" indicates "nanoparticle"). This implies that multiple wavelengths are detected simultaneously.

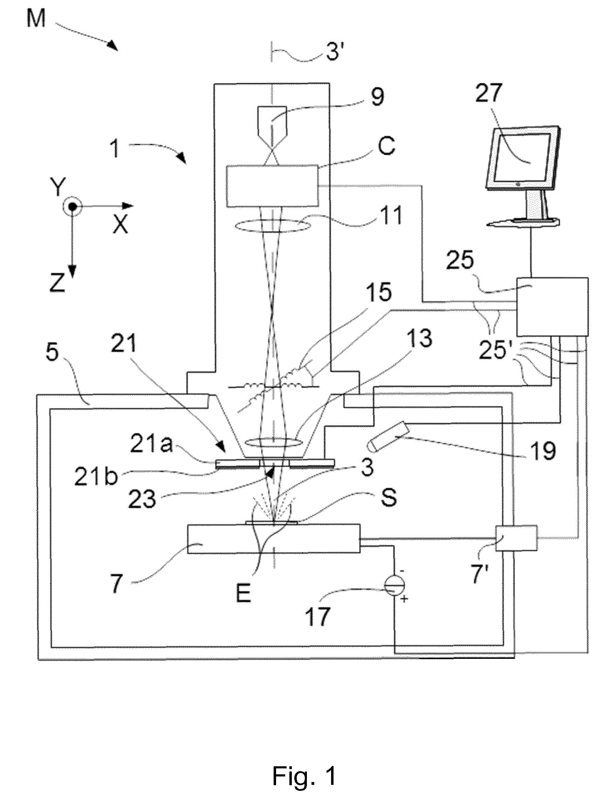

Another such detector is known from the publication "Cathodoluminescence microscopy: optical imaging and spectroscopy with deep-sub-wavelength resolution", T. Coenen et al., MRS Bulletin 40, pp. 359-365, April 2015, further referred to as "Coenen" [-1-]. In its figure 1^{d}, a set-up is shown in which light emitted by the sample is focused by a parabolic mirror into a fiber and guided to a spectrometer. The spectrometer, using a CCD (Charge-Coupled Device), detects several colors simultaneously. Here the pixels of the CCD are arranged as groups of sensitive surfaces, each group responsive to one color.

Yet another such detector is known from the publication "Correlative light and electron microscopy using cathodoluminescence from nanoparticles with distinguishable colors", D.R. Glenn et al., Scientific reports 2, published 15 Nov, 2012, DOI 10.1038/srep00865, further referred to as "Glenn" [-2-]. Glenn's figure 1 shows an elliptical mirror to guide photons from the sample to a photomultiplier, and an interference filter between the sample and the photomultiplier.

A problem with all the aforementioned detectors is their relatively high price. Another problem with all the aforementioned detectors is that the position of the sample must be kept in the focus of the employed parabolic or elliptical mirror, thereby demanding extra positioning time and/or limited freedom in positioning. Moreover, the employed light collection optics are bulky (in an area that is already cramped), and tend to (at least partially) block the paths of other types of radiation (such as backscattered electrons, secondary electrons and/or X-rays) emanating from the sample, impeding their passage to their respective detectors and thus limiting possibilities for simultaneous signal acquisition.

It is an object of the invention to offer an alternative to the aforementioned detectors. In particular, it is an object of the invention that the alternative detector be cheaper than relevant prior-art detectors, and that demands *vis-à-vis* the position of the sample in relation to the detector be less stringent. It is furthermore an object of the invention that the alternative detector be less bulky/obstructive than in the prior art, thereby facilitating simultaneous acquisition of multiple signal species, if desired.

These and other objects are achieved in a detector as set forth in the opening paragraph above, characterized in that it comprises:
- A plurality of photosensitive surfaces, each of which produces an output signal in response to detected photonic radiation; and
- A plurality of optical filters, with mutually differing transmission characteristics, each associated with a respective one of said photosensitive surfaces and serving to filter photonic radiation falling thereon.

With such a structure, one is capable of performing parallel multi-spectral CL detection, without the need to use a dispersive optical element (such as a grating or prism).

Each employed filter may be a cutoff or bandpass filter, as desired. In the latter case, the filter may, if desired, be configured to (at least partially) pass multiple spectral regions. The filters may, for example, comprise colored/doped/coated glass, quartz or plastic (or another dielectric material). Other categories of filter include, for example, dichroic hot/cold mirrors and Liquid Crystal tunable filters.

The use of absorption optical filters is much cheaper than the use of spectroscopes (Coenen) or interference filters (Glenn). With three filters, one can, for example, acquire an RGB (Red-Green-Blue) image; supplementally, a fourth filter can be used to acquire a UV (ultraviolet) image, for example. By omitting a filter altogether, a panchromatic image can be acquired.

If desired, the size of the employed photosensitive surfaces (elements, members) can be tuned in accordance with the ratios of (for example) RGB in the (expected) image: if, for example, the sample does not emit much red, but abundant green light, then the surface area of the photosensitive surface associated with red light can be made larger than that associated with green light, in order to realize a comparable SNR (Signal-to-Noise Ratio) for the red and green signal components.

If - as in the case of correlative microscopy, for example - it is desirable to detect both CL and other types of radiation - such as Back-Scattered Electrons (BSEs) or Secondary Electrons (SEs), for example - then this can, for example, be achieved by:
- Using separate detectors (*e.g*. one for CL and one for electrons); or
- Using one detector that is sensitive to both types of radiation (*e.g*. whereby part of the detector is sensitive to electrons, and other parts to different colors of CL).
Providing a supplementary electron-sensitive surface on the inventive detector can be a clever way of making improved use of the (generally) very-limited available volume between the sample and a terminal portion of the illuminator.

A composite-color CL image can be formed by taking three separate images - *e.g*. one using a red filter, one using a green filter and one using a blue filter- and then combining the three images into one composite image. However, possible disadvantages of this approach include the following:
- The sample may positionally drift during the time that it takes to acquire the three images;
- Exchanging employed filters between acquisition of the separate images costs time/throughput, and may also introduce unwanted sample movement and/or detector movements;
- The sample may deteriorate during the image acquisition process, whereby the first image captures a 'pristine' sample but the last image renders a damaged sample.
Such disadvantages can be mitigated by acquiring the component images simultaneously.

By locating the employed detector *in situ* within said vacuum chamber - preferably between the sample and illuminator- no dedicated optics (such as a fiber, mirror, lenses, or combinations thereof) are needed to guide the CL light to the detector (in contrast to the *ex situ* set-ups described in the abovementioned prior-art documents). Moreover, a detector in this location is afforded a relatively large field of view (large capture angle).

The employed detector preferably comprises a central hole/opening for passing the (probing beam of) charged particles that irradiate the sample, e.g. as known in annular electron detectors (see, for example, European Patent No. EP 2 518 755). This opening can, for example, act as a pressure-limiting aperture for a CPM operating in environmental / low-pressure mode, as in the case of an ESEM (Environmental SEM), for instance.

If it is located within said vacuum chamber, then the inventive detector can preferably be withdrawn from a vicinity of said axis, *e.g*. by translating or swiveling it aside so as to get it out of the way when not in use.

As is well known to the person skilled in the art, different inspection methods demand different detectors. Examples of such different detectors are X-ray detectors, backscattered electron detectors, and detectors for detecting and analyzing transmitted electrons, such as dark field detectors, bright field detectors, post-column filters, *etc.* To enable a change of inspection method, one (group of) detectors is preferably exchangeable with another, whence the advantage of a withdrawable CL detector.

However, it must be borne in mind that the relatively thin / less-bulky design allowed by the present invention is less obstructive of other types of radiation emanating from the sample (such as backscattered electrons, secondary electrons and X-rays), thereby allowing such signals to be detected simultaneously / sequentially without necessarily having to withdraw/retract the inventive CL detector. This saves time, and avoids disturbance that might otherwise cause/worsen nuisances such as such as primary beam shift, aberrations, *etc.*

In an advantageous embodiment of the invention, the detector comprises a Silicon Photomultiplier (SiPM) - also sometimes referred to as a Solid State Photomultiplier (SSPM) or Multi-Pixel Photon Counter (MPPC^{®}). An SiPM has *inter alia* the advantage of being small, cheap and vacuum-compatible, and it can be used to detect photons and electrons (without having to use a scintillator). The innovative use of an SiPM as a detector in a CPM is described in more detail in United States Patents US 8,735,849 and US 9,153,416 (incorporated herein by reference), which have several inventors in common with the present invention.

In an embodiment as set forth in the previous paragraph, one could, for example:
- Use a separate SiPM for each of the employed photosensitive surfaces (and, if desired, for any supplementary electron-sensitive surfaces included in the detector design); or
- Make use of a shared SiPM, in which each photosensitive (or electron-sensitive) surface is formed by a different subset/group of pixels on a common SiPM.

As an alternative to using SiPMs, one could instead configure one or more of the photosensitive surfaces to comprise a photodiode, CCD or CMOS sensor, for example.

In a particularly versatile embodiment of the invention, the following applies:
- At least a subset of said optical filters can be demounted from the detector and exchanged;
- The microscope comprises:
   □ A library, in which a selection of filters can be stored;
   □ An exchanger mechanism, for transferring filters between the library and detector, and mounting/demounting them to/from the detector.

Such an arrangement is advantageous *inter alia* in that it provides an *in situ* way of allowing specific (spectrally tailored) color filters to be retrieved and used at will, without having to break vacuum, for example. Moreover, it allows one or more filters to be (temporarily) removed with the express purpose of leaving the associated photosensitive surface(s) "naked"; such an arrangement can, for example, be useful if the employed photosensitive surfaces are also electron-sensitive, *e.g*. as in the case of a SiPM as set forth above. The employed library could, for instance, be embodied as a rack or carrousel, and the exchanger mechanism could, for example, comprise a SCARA robot arm or similar such device. The filters could, for example, be affixed to the detector by way of a click/unclick mechanism, or by sliding them into (and, later, out of) a retaining groove.

In a particular embodiment of the invention, the employed optical filters are co-mounted on a common, movable member that can be retracted from said photosensitive surfaces. Such an arrangement can, for example, be useful if the employed photosensitive surfaces are also electron-sensitive, *e.g*. as in the case of a SiPM as discussed above; in such an instance, removing all filters in one go allows the detector to be used as a segmented electron detector, for instance.

Although not intrinsically necessary, the present invention can, in certain situations, nevertheless be enhanced by actively guiding CL flux from the irradiated sample towards the photosensitive surfaces of the detector, *e.g*. using a light guide (comprising one or more optical fibers, for instance), or one or more mirrors. This can serve to further increase the capture angle that can be registered by the detector; this, in turn, allows the detector to be located "off-axis" (off to one (lateral) side of the probing beam, for example), which may allow more efficient/versatile use of available detection volume in the environs of the sample.

In another embodiment of the invention, at least one of the employed optical filters passes substantially all wavelengths in a visible light band, but stops electrons emanating from the sample. Such a configuration is effectively a visible-light window that acts as an electron blocker. Allowing a cumulative visible-light spectrum to be detected in this manner can, for example, be useful in quantitative measurements, in which a total (integrated) intensity can be used to derive a quantity of emitting material present in a given sample. In addition, a white-light standard can act as a useful reference for expressing the intensity of a given specific wavelength or color.

The skilled person will be able to contrive many variations as regards types and combinations of filters in the present invention. For example, since UV can also contribute to the detected light, a white-light channel can be dedicated to detecting all light, after which proper subtraction of RGB will then yield the amount of UV present; in this way, one can eliminate the need to use a dedicated UV filter. Another possible embodiment is a detector with a red, a blue and a white filter (passing red, blue, and all colors, respectively), in which green information is obtained by subtracting from the white signal proportional to the red and blue signals.

If desired, an element such as a Fresnel lens can be used to transform an inherently diverging beam from a spot source (on the sample) into a (quasi-)parallel beam. In such an instance, interference optics (*e.g*. an interference bandpass filter or low-high-pass filter) can be used to manipulate the spectral characteristics of the radiation.

Also, if desired, one can employ separate analog and digital signal processing of each spectral channel, allowing independent gain tuning and signal filtering, for example.

Moreover, it is possible to embody the employed filters / acquisition chain so as to achieve an on-screen color CL image that mimics colors as perceived by the human eye (true color imaging).

A particular aspect of the invention relates to a method of investigating a sample using a charged particle microscope, comprising the steps of:
- Providing the sample on a sample holder;
- Using a source to produce a probing beam of charged particles;
- Using an illuminator to direct said beam along an axis so as to irradiate the sample,
- Using a detector to simultaneously detect multiple wavelengths in a polychromatic flux of photonic radiation emanating from the sample in response to said irradiation,
**wherein** said detector is a detector according to the present invention

In an embodiment of such a method, the sample comprises at least one optical marker, which emits photonic radiation when irradiated with charged particles. Examples of such markers include nanodots, fluorescent dyes, and fluorophores, for instance.

The use of such optical markers for inspection of biological samples in electron microscopy is well known to the skilled person. The employed optical markers can, for example, be comprised in / adhered to proteins, enzymes, *etc.* More information on this topic can, for example, be gleaned from the following reference:

### https://en.wikipedia.org/wiki/Fluorescent tag

In a further embodiment, at least one of the optical filters of the inventive detector transmits a part of a spectrum in which the employed optical marker emits radiation. By configuring one or more of the optical filters to pass the (known) wavelength of one or more types of optical markers, the optical markers in question can be readily spotted in a (biological) sample under investigation.

Apart from uses in biological studies, it is noted that certain minerals also emit photons (fluoresce) at specific wavelengths, and that observing at these wavelengths can thus give an indication of the presence or absence of the minerals in question.

It is, of course, possible to choose a specific set of optical filters that matches the spectrum of CL emission from certain specific materials of interest in a particular field of study. Such materials of interests might, for example, be organic fluorophores or nanoparticles (markers) in life science applications, certain classes of minerals in soil studies, specific phases or types of substance in materials science applications (*e.g.* metal versus ceramics debris), *etc.*

The invention will now be elucidated in more detail on the basis of exemplary embodiments and the accompanying schematic drawings, in which:
- Figure 1 renders a longitudinal cross-sectional view of a CPM in which the present invention is implemented.
- Figure 2 renders a magnified view of part of Figure 1, more particularly a detector according to the present invention.
In the Figures, where pertinent, corresponding parts may be indicated using corresponding reference symbols.

### Embodiment 1

Figure 1 is a highly schematic depiction of an embodiment of a CPM in which the present invention is implemented; more specifically, it shows an embodiment of a microscope M, which, in this case, is a SEM (though, in the context of the current invention, it could just as validly be a (S)TEM, or an ion-based microscope, for example). The microscope M comprises an illuminator (particle-optical column) 1, which produces a probing (primary) beam 3 of input charged particles (in this case, an electron beam) that propagates along a particle-optical axis 3'. The illuminator 1 is mounted on a vacuum chamber 5, which comprises a sample holder 7 and associated stage/actuator 7' for holding/positioning a sample S. The vacuum chamber 5 is evacuated using vacuum pumps (not depicted). With the aid of voltage supply 17, the sample holder 7, or at least the sample S, may, if desired, be biased (floated) to an electrical potential with respect to ground.

The illuminator 1 (in the present case) comprises an electron source 9 (such as a Schottky gun, for example), lenses 11, 13 to focus the electron beam 3 onto the sample S, and a deflection unit 15 (to perform beam steering / scanning of the beam 3). The apparatus M further comprises a controller / computer processing apparatus 25 for controlling *inter alia* the deflection unit 15, lenses 11, 13 and detectors 19, 21, and displaying information gathered from the detectors 19, 21 on a display unit 27.

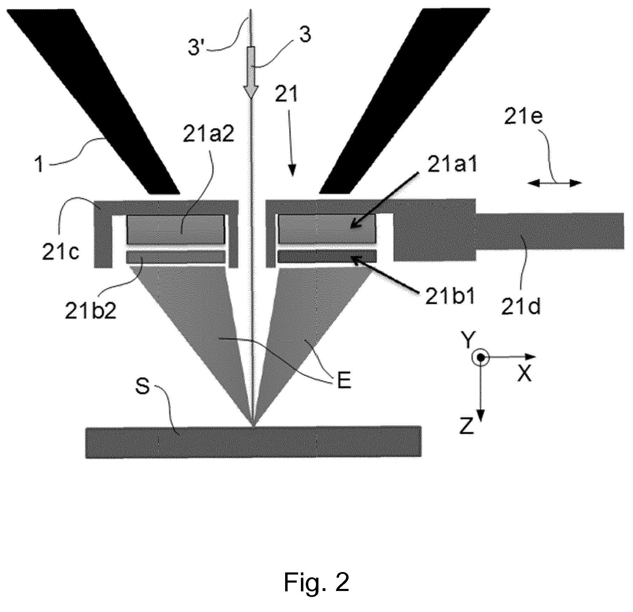

The detectors 19, 21 are chosen from a variety of possible detector types that can be used to examine different types of output radiation E emanating from the sample S in response to irradiation by the input beam 3. In the apparatus depicted here, the following (non-limiting) detector choices have been made:
- Detector 19 is, for example, an X-ray detector, such as Silicon Drift Detector (SDD) or Silicon Lithium (Si(Li)) detector. Alternatively, it could be an electron detector, such as an Everhart-Thornley detector or SiPM, for instance. It may, if desired, be movable, *e.g*. so as to allow it to capture specific angular ranges of the flux E.
- Detector 21 is a detector according to the present invention, for simultaneous detection of multiple wavelengths of CL light in the output radiation E. The detector 21 comprises a plurality of independent detection segments / photosensitive surfaces 21 a (which may, for example, be quadrant-shaped, rectangular, circular, *etc*.) and associated optical filters 21b, disposed (*e.g.* in annular/perimetric configuration) about a central aperture 23 (allowing passage of the primary beam 3). This structure is illustrated in more detail in Figure 2, and is further discussed below.
The skilled artisan will understand that many different types of detector can be chosen in a set-up such as that depicted. For example, an annular, segmented electron detector could be used, which might, for instance, be arranged:
- Outside a perimeter of detector 21; or
- Behind detector 21 (as seen from the sample S), and accessible to the radiation E by using an appropriate mechanism (*e.g*. electrical, mechanical and/or pneumatic) to withdrawn detector 21 away from the on-axis location depicted in Figures 1 and 2 and park it in a marginal location.

By scanning the input beam 3 over the sample S, output radiation - generally comprising CL (infrared/visible/ultraviolet light), secondary electrons (SEs) and/or backscattered electrons (BSEs), and X-rays - emanates from the sample S. Since such output radiation is position-sensitive (due to said scanning motion), the information obtained from the detectors 19, 21 will also be position-dependent. This fact allows (for instance) the signal from detector 21 to be used to produce a multicolored CL image of (part of) the sample S, which image is basically a map of said signal as a function of scan-path position on the sample S.

The signals from the detectors 19, 21 pass along control lines (buses) 25', are processed by the controller 25, and can be displayed on display unit 27. Such processing may include operations such as combining, integrating, subtracting, false coloring, edge enhancing, and other processing known to the skilled artisan. In addition, automated recognition processes (*e.g*. as used for particle analysis) may be included in such processing.

It should be noted that many refinements and alternatives of such a set-up will be known to the skilled artisan, including, but not limited to:
- The use of dual beams - for example an electron beam 3 for imaging and an ion beam for machining (or, in some cases, imaging) the sample S;
- The use of a controlled environment at the sample S - for example, maintaining a pressure of several mbar (as used in a so-called Environmental SEM) or by admitting gases, such as etching or precursor gases, *etc.*

### Embodiment 2

With regard to Figure 2, this shows an enlarged view of part of Figure 1 - more specifically the vicinity of the inventive detector 21. The Figure shows two photosensitive surfaces 21 a1, 21 a2, though a greater number is also possible. Associated with these two photosensitive surfaces 21a1, 21 a2, is a corresponding pair of optical filters 21 b1, 21 b2, which have mutually differing transmission characteristics (*e.g*. different cutoff points and/or bandpass windows). These optical filters 21 b1, 21 b2 are positioned so as to intercept (part of) the output radiation E emanating from the sample S, and serve to filter/select CL components (infrared/visible/ultraviolet light) contained therein before they can reach the respective photosensitive surfaces 21 a1, 21 a2. The photosensitive surfaces 21 a1, 21 a2 are attached to a detector frame 21 c which may, for example, be made of metal, ceramic, vacuum-compatible plastic, *etc.* The filters 21 b1, 21 b2 may be attached to their respective photosensitive surfaces 21 a1, 21 a2 (*e.g*. using direct bonding, peripheral gluing/molding, *etc*.), or may be just (removably) held in front thereof by (part of) the frame 21c (*e.g*. using screws, clips, a click-release mechanism, a retaining groove, *etc*.)*.*

As a non-binding example, the photosensitive surfaces 21 a1, 21 a2 may each have dimensions of ca. 3 mm x 3 mm, and the optical filters may have a thickness of *ca.* 0.2 mm - though the skilled person will understand that many other size choices are possible.

In the particular situation depicted here, the detector frame 21 c is attached to an arm 21 d that can be used to withdraw (or simply positionally adjust) the detector 21, *e.g.* by translating it in the direction of arrows 21 e, by swiveling it, *etc.* In this way, the detector 21 can be gotten out of the vicinity of axis 3' / sample S, and, for example, moved to a parking position.

As an alternative/supplement to the scenario described in the previous paragraph, one could also just remove the filters 21 b1, 21 b2, so as to leave the photosensitive surfaces "naked"; in such a scenario, the detector 21 could then, for example, double-up as an (angularly-resolved) electron detector, assuming that the photosensitive surfaces 21 a1, 21 a2 were also suited to detecting electrons (as in the case of SiPMs, for instance). As an alternative/supplement hereto, one could also mount a separate, dedicated, electron-sensitive surface (not depicted) on the frame 21c.

Although not depicted in Figure 2 - and not required by the present invention - one could, if desired, use optical fibers, mirrors, *etc.,* to (more effectively) guide/concentrate the CL components of the radiation E toward the photosensitive surfaces 21 a1, 21 a2; in such a scenario, the detector 21 could be located off-axis, if so desired.

## Claims

1. A charged particle microscope having a vacuum chamber comprising:
- A sample holder, for holding a sample;
- A source, for producing a probing beam of charged particles;
- An illuminator, for directing said beam along an axis so as to irradiate the sample, also comprising:
- A detector, for simultaneous detection of multiple wavelengths in a polychromatic flux of photonic radiation emanating from the sample in response to said irradiation,
**characterized in that** said detector comprises:
- A plurality of photosensitive surfaces, each of which produces an output signal in response to detected photonic radiation; and
- A plurality of optical filters, with mutually differing transmission characteristics, each associated with a respective one of said photosensitive surfaces and serving to filter photonic radiation falling thereon.

2. A microscope according to claim 1, wherein said photosensitive surfaces are located within said vacuum chamber.

3. A microscope according to claim 2, wherein the detector can be withdrawn from a vicinity of said axis.

4. A microscope according to any preceding claim, wherein the detector is disposed between said sample and source.

5. A microscope according to any preceding claim, wherein the detector additionally comprises an electron-sensitive surface.

6. A microscope according to any preceding claim, wherein each of said photosensitive surfaces is comprised in a Silicon Photomultiplier.

7. A microscope according to claim 6, wherein each of said photosensitive surfaces comprises a different group of pixels on a shared Silicon Photomultiplier.

8. A microscope according to any preceding claim, wherein:
- At least a subset of said optical filters can be demounted from the detector and exchanged;
- The microscope comprises:
□ A library, in which a selection of filters can be stored;
□ An exchanger mechanism, for transferring filters between the library and detector, and mounting/demounting them to/from the detector.

9. A microscope according to any preceding claim, wherein said optical filters are co-mounted on a common, movable member that can be retracted from said photosensitive surfaces.

10. A microscope according to any preceding claim, wherein said flux of photonic radiation is guided towards said photosensitive surfaces using an optical element selected from the group comprising light guides, mirrors, and combinations hereof.

11. A microscope according to any preceding claim, wherein at least one of said optical filters passes substantially all wavelengths in a visible light band, but stops electrons emanating from the sample.

12. A method of investigating a sample using a charged particle microscope, comprising the following steps:
- Providing the sample on a sample holder;
- Using a source to produce a probing beam of charged particles;
- Using an illuminator to direct said beam along an axis so as to irradiate the sample,
- Using a detector to simultaneously detect multiple wavelengths in a polychromatic flux of photonic radiation emanating from the sample in response to said irradiation,
**characterized in that** said detector is configured to comprise:
- A plurality of photosensitive surfaces, each of which produces an output signal in response to detected photonic radiation; and
- A plurality of optical filters, with mutually differing transmission characteristics, each associated with a respective one of said photosensitive surfaces and serving to filter photonic radiation falling thereon.

13. A method according to claim 12, wherein the sample comprises at least one optical marker, which emits photonic radiation when irradiated with charged particles.

14. A method according to claim 13, wherein said optical marker is selected from the group comprising nanodots, fluorescent dyes, fluorophores, and combinations hereof.

15. A method according to any of claims 12-14, wherein at least one of said optical filters transmits a part of a spectrum in which said optical marker emits radiation.
